# EUROPÄISCHE PATENTSCHRIFT

(11) **EP 2 862 009 B1**
(45) Veröffentlichungstag und Bekanntmachung des Hinweises auf die Patenterteilung: **26.03.2025**
(21) Anmeldenummer: 13717252.4
(22) Anmeldetag: 15.04.2013
(51) Int. Cl.: G01V 3/15

(54) **HANDWERKZEUGVORRICHTUNG**
HAND TOOL DEVICE
SYSTÈME D'OUTIL PORTATIF

(30) Priorität: 14.06.2012 DE 102012210009
(43) Veröffentlichungstag der Anmeldung: 22.04.2015
(73) Patentinhaber: Robert Bosch GmbH, 70442 Stuttgart (DE)
(72) Erfinder: SGARZ, Heiko, 71229 Leonberg (DE); BROSI, Jan-Michael, 70771 Leinfelden-Echterdingen (DE); ALBRECHT, Andrej, 70567 Stuttgart (DE)
(86) Internationale Anmeldenummer: PCT/EP2013/057789
(87) Internationale Veröffentlichungsnummer: WO 2013/185947

(56) Entgegenhaltungen:
- WO-A1-2005/111663
- WO-A2-2006/098751
- US-A1- 2008 036 644
- US-A1- 2010 085 234
- US-B1- 6 512 475

## Beschreibung

### Stand der Technik

Es ist bereits eine Handwerkzeugvorrichtung mit zumindest einer Ortungsvorrichtung, die dazu vorgesehen ist, eine niederfrequente Wechselspannung in einem Werkstück zu orten und die eine erste Ortungsantenne und eine zweite Ortungsantenne aufweist, vorgeschlagen worden. Ferner sind bereits Handwerkzeugvorrichtungen mit Abschirmmitteln vorgeschlagen worden (vgl. beispielsweise US 6,512,475 B1, WO 2006/098751 A2 oder US 2010/085234 A1).

Aus der US 2008/036644 A1 ist ein Radargerät zur Ortung von in einem Medium eingeschlossenen Objekten bekannt, mit zumindest einem Radar-Sensor, der ein erstes, hochfrequentes Detektionssignal zum Eingriff in ein zu untersuchendes Medium erzeugt, so dass durch Messung und Auswertung des reflektierten Detektionssignals des Radarsensors, Informationen über ein in dem Medium eingeschlossenes Objekt gewonnen werden können.

### Offenbarung der Erfindung

Die Erfindung geht aus von einer Handwerkzeugvorrichtung gemäß Anspruch 1 mit zumindest einer Ortungsvorrichtung, die dazu vorgesehen ist, eine niederfrequente Wechselspannung in einem Werkstück zu orten und die eine erste Ortungsantenne und eine zweite Ortungsantenne aufweist.

Es wird vorgeschlagen, dass die Handwerkzeugvorrichtung ein Abschirmmittel zur Abschirmung eines niederfrequenten Ortungssignals aufweist, das zwischen der ersten Ortungsantenne und der zweiten Ortungsantenne angeordnet ist. Unter einer "Ortungsvorrichtung" soll insbesondere eine Vorrichtung verstanden werden, die dazu vorgesehen ist, zumindest eine Ortsinformation über ein in einem Werkstück angeordnetes Messobjekt zu bestimmen. Vorzugsweise weist die Ortungsvorrichtung eine Recheneinheit auf, die dazu vorgesehen ist, zumindest eine Richtung und/oder eine Entfernung des Messobjekts relativ zu der Ortungsvorrichtung zu bestimmen. Bevorzugt weist die Ortungsvorrichtung ein Ausgabemittel auf, über das die Ortungsvorrichtung die Ortsinformation an einen Bediener ausgibt. Insbesondere soll unter "vorgesehen" speziell programmiert, ausgelegt und/oder ausgestattet verstanden werden. Unter einer "niederfrequenten Wechselspannung" soll insbesondere eine Spannung mit einer Frequenz kleiner als 100 kHz, vorteilhaft kleiner als 10 kHz, besonders vorteilhaft kleiner als 1 kHZ, verstanden werden. Vorzugsweise ist die Ortungsvorrichtung dazu vorgesehen, eine Netzspannung mit 50 Hz und/oder 60 Hz zu orten. Insbesondere soll unter der Wendung "in einem Werkstück" verstanden werden, dass die Ortungsvorrichtung dazu vorgesehen ist, das innerhalb von und/oder hinter dem Werkstück verdeckt angeordnete Messobjekt zu orten. Vorzugsweise ist die Ortungsvorrichtung dazu vorgesehen, ein Ortungssignal, das das Werkstück durchdrungen hat, zu empfangen. Unter "orten" soll insbesondere eine Bestimmung zumindest einer Ortsinformation eines entfernt und verdeckt angeordneten Messobjekts verstanden werden. Insbesondere soll unter einer "Ortungsantenne" ein Mittel verstanden werden, das dazu vorgesehen ist, ein elektrisch, magnetisch und/oder elektromagnetisch übertragenes Ortungssignal in ein von einem elektrischen Leiter übertragenes Signal zu wandeln. Unter einem "Abschirmmittel" soll insbesondere ein Mittel verstanden werden, das dazu vorgesehen ist, ein aus einer Richtung auf die Ortungsantenne wirkendes niederfrequentes Ortungssignal um mehr als 6 dB, vorteilhaft um mehr als 10 dB, besonders vorteilhaft um mehr als 20 dB, abzuschwächen. Insbesondere beeinflusst das Abschirmmittel eine Hauptortungsrichtung der Ortungsantennen. Vorzugsweise ist das Abschirmmittel als eine elektrisch leitende Schicht ausgebildet. Alternativ oder zusätzlich könnte das Abschirmmittel ein leitendes Gitter, leitende Streifen, leitende Teilflächen und/oder andere, dem Fachmann als sinnvoll erscheinende leitende Elemente aufweisen. Bevorzugt ist das Abschirmmittel als ein Blech und/oder vorteilhaft als eine Beschichtung eines Isolators, beispielsweise als ein metallisiertes Kunststoffteil oder als eine Leiterplatte, ausgebildet. Beispielsweise könnte das Abschirmmittel Kupfer, Eisen, Ferrit und/oder Mumetall aufweisen. Vorzugsweise weist das Abschirmmittel ein festes elektrisches Potential auf, beispielsweise könnte es mit einer Masse der Ortungsvorrichtung elektrisch leitend verbunden sein. Alternativ könnte es gegenüber der Ortungsvorrichtung elektrisch isoliert sein. Insbesondere soll unter einem "niederfrequenten Ortungssignal" ein Signal mit einer Frequenz kleiner als 1 kHz verstanden werden. Unter dem Begriff "zwischen" soll in diesem Zusammenhang insbesondere verstanden werden, dass das Abschirmmittel auf zumindest einer Geraden liegt, die auf zwei entgegengesetzten Seiten des Abschirmmittels jeweils eine der Ortungsantennen schneidet. Vorzugsweise liegt das Abschirmmittel zwischen jedem Punkt der ersten Ortungsantennen und, von dem Punkt ausgehend, zumindest 50 %, vorteilhaft 75 %, besonders vorteilhaft 90 %, einer Fläche der zweiten Ortungsantenne. Durch die erfindungsgemäße Ausgestaltung der Handwerkzeugvorrichtung kann konstruktiv einfach erreicht werden, dass Hauptortungsrichtungen der Ortungsantennen unterschiedlich ausgerichtet sind.

Dadurch kann eine besonders vorteilhafte Ortsbestimmung der niederfrequenten Wechselspannung erreicht werden.

In einer weiteren Ausgestaltung wird vorgeschlagen, dass die Ortungsantennen symmetrisch zu dem Abschirmmittel angeordnet sind, wodurch eine besonders einfache Bestimmung der Ortsinformation mit einer Recheneinheit möglich ist. Unter "symmetrisch angeordnet" soll insbesondere verstanden werden, dass Mittelpunkte der Ortungsantennen relativ zu einer durch einen Mittelpunkt des Abschirmmittels laufenden Symmetriefläche regelmäßig angeordnet sind.

Des Weiteren wird vorgeschlagen, dass die erste und/oder die zweite Ortungsantenne von einer leitenden Schicht gebildet ist, wodurch eine besonders kostengünstige Fertigung möglich ist. Des Weiteren lassen sich die Ortungsantennen besonders platzsparend platzieren. Unter einer "leitenden Schicht" soll insbesondere ein leitender Bereich verstanden werden, dessen Dicke weniger als 10 % einer Höhe und eine Breite des Bereichs beträgt. Vorzugsweise sind die Ortungsantennen jeweils als ein Blech und/oder vorteilhaft als eine Beschichtung eines Isolators, beispielsweise als ein metallisiertes Kunststoffteil oder als eine Leiterplatte, ausgebildet.

Ferner wird vorgeschlagen, dass die Handwerkzeugvorrichtung eine zweite Ortungsvorrichtung mit zumindest einer Ortungsantenne umfasst, wobei das Abschirmmittel die Ortungsantenne der zweite Ortungsvorrichtung zumindest im Wesentlichen umschließt, wodurch konstruktiv einfach in eine weitere Ortungsrichtung geortet werden kann. Insbesondere soll unter der Wendung "auf wenigstens einer Ebene zumindest im Wesentlichen umschließen" verstanden werden, dass von dem Mittelpunkt der Ortungsantenne ausgehende Strahlen, die auf der Ebene angeordnet sind, das Abschirmmittel über einem Winkelbereich von mehr als 180 Grad, vorteilhaft mehr als 270 Grad schneiden. Besonders vorteilhaft umschließt das Abschirmmittel die Ortungsantenne der dritten Ortungsvorrichtung um 360 Grad.

Zudem wird vorgeschlagen, dass die zweite Ortungsvorrichtung dazu vorgesehen ist, mit einem hochfrequenten Ortungssignal zu orten, wodurch spannungsfreie Messobjekte vorteilhaft geortet werden können. Vorzugsweise ist die Ortungsantenne der zweiten Ortungsvorrichtung wie in der Druckschrift DE 10 2008 041 651 A1 beschrieben ausgebildet. Alternativ oder zusätzlich könnte die Ortungsantenne der zweiten Ortungsvorrichtung dazu vorgesehen sein, ein Messobjekt induktiv und/oder kapazitiv zu orten. Des Weiteren könnte die zweite Ortungsvorrichtung dazu vorgesehen sein, eine niederfrequente Wechselspannung zu orten. Insbesondere soll unter einem "hochfrequenten Ortungssignal" ein Ortungssignal mit einer Frequenz größer als 1 KHz, vorteilhaft größer als 1 MHz, verstanden werden. Vorzugsweise ist die dritte Ortungsvorrichtung dazu vorgesehen, mit einem Ultrabreitbandsignal zu orten. Unter einem "Ultrabreitbandsignal" soll insbesondere ein Ortungssignal mit einer Mittelfrequenz im Frequenzbereich von 250 MHz bis 15 GHz und einer Frequenzbandbreite von zumindest 500 MHz verstanden werden. Alternativ oder zusätzlich könnte die zweite Ortungsvorrichtung dazu vorgesehen sein, mit einem smallbandigen Ortungssignal zu orten.

Weiterhin wird vorgeschlagen, dass die erste und die zweite Ortungsantenne symmetrisch zu der Ortungsantenne der zweiten Ortungsvorrichtung angeordnet sind, wodurch eine besonders einfache Bestimmung der Ortsinformation mit einer Recheneinheit möglich ist.

In einer vorteilhaften Ausbildung der Erfindung wird vorgeschlagen, dass die erste und die zweite Ortungsantenne eine Haupterstreckung aufweisen, die im Wesentlichen parallel zu einer Hauptortungsrichtung der Ortungsantenne der zweiten Ortungsvorrichtung ausgerichtet ist, wodurch eine besonders platzsparende Ausgestaltung der Handwerkzeugvorrichtung erreicht werden kann. Unter einer "Haupterstreckungsebene" soll insbesondere eine Ebene mit einer maximalen Erstreckung verstanden werden. Insbesondere soll unter "im Wesentlichen parallel" verstanden werden, dass eine Erstreckung der Haupterstreckungsebene weniger als 20 Grad, vorteilhaft weniger als 10 Grad, von der Hauptortungsrichtung abweicht. Unter einer "Hauptortungsrichtung" soll insbesondere eine Richtung verstanden werden, in der die Ortungsantenne eine maximale Empfindlichkeit aufweist. Bei einer Ortungsantenne, die dazu vorgesehen ist, eine maximale Energie in unterschiedlichen Betriebszuständen in unterschiedliche Richtungen auszusenden, soll unter der "Hauptortungsrichtung" vorteilhaft eine mittlere Richtung der unterschiedlichen Richtungen verstanden werden.

Des Weiteren wird vorgeschlagen, dass die Handwerkzeugvorrichtung eine FunktionsÖffnung aufweist, wobei zumindest zwei der Ortungsantennen, insbesondere die Ortungsantennen der ersten und einer zweiten Ortungsvorrichtung, symmetrisch zu der Funktionsöffnung angeordnet sind, wodurch das Werkstück komfortabel an einer Stelle bearbeitet und/oder markiert werden kann, an der eine Ortung durchgeführt wurde. Unter einer "Funktionsöffnung" soll insbesondere eine Öffnung der Handwerkzeugvorrichtung verstanden werden, durch die ein Funktionsmittel, beispielsweise ein Bohrer und/oder ein Stift, zu dem Werkstück geführt werden kann, während ein Gehäuse eines die Handwerkzeugvorrichtung aufweisenden Geräts mit einer Ortungsseite an das Werkstück angelegt ist.

Ferner wird vorgeschlagen, dass die erste Ortungsvorrichtung eine dritte Ortungsantenne und eine vierte Ortungsantenne aufweist, wobei das Abschirmmittel zwischen der dritten Ortungsantenne und der vierten Ortungsantenne angeordnet ist, wodurch eine besonders genaue Ortung der niederfrequenten Wechselspannung möglich ist.

Des Weiteren geht die Erfindung aus von einem Handwerkzeug mit einer Handwerkzeugvorrichtung. Insbesondere soll unter einem "Handwerkzeug" ein, dem Fachmann als sinnvoll erscheinendes Werkzeug, vorteilhaft jedoch eine Bohrmaschine, ein Bohrhammer, ein Schlaghammer, eine Säge, ein Hobel, ein Schrauber, eine Fräse, ein Schleifer, ein Winkelschleifer, ein Gartengerät, ein Multifunktionswerkzeug und/oder besonders vorteilhaft ein Baustellenmessgerät verstanden werden.

### Zeichnung

Weitere Vorteile ergeben sich aus der folgenden Zeichnungsbeschreibung. In der Zeichnung sind vier Ausführungsbeispiele der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: ein Handwerkzeug mit einer erfindungsgemäße Handwerkzeugvorrichtung,
- Fig. 2: vier Ortungsantennen einer ersten Ortungsvorrichtung, eine Ortungsantenne einer zweiten Ortungsvorrichtung und ein Abschirmmittel der Handwerkzeugvorrichtung aus Figur 1 in einer perspektivischen Ansicht,
- Fig. 3: einen schematischen Schnitt der Handwerkzeugvorrichtung aus Figur 1,
- Fig. 4: einen schematischen Schnitt eines zweiten, alternativen Ausführungsbeispiels der Handwerkzeugvorrichtung aus Figur 1,
- Fig. 5: einen schematischen Schnitt eines dritten, alternativen Ausführungsbeispiels der Handwerkzeugvorrichtung aus Figur 1, das kein Bestandteil der vorliegenden Erfindung ist und
- Fig. 6: einen schematischen Schnitt eines vierten, alternativen Ausführungsbeispiels der Handwerkzeugvorrichtung aus Figur 1.

### Beschreibung der Ausführungsbeispiele

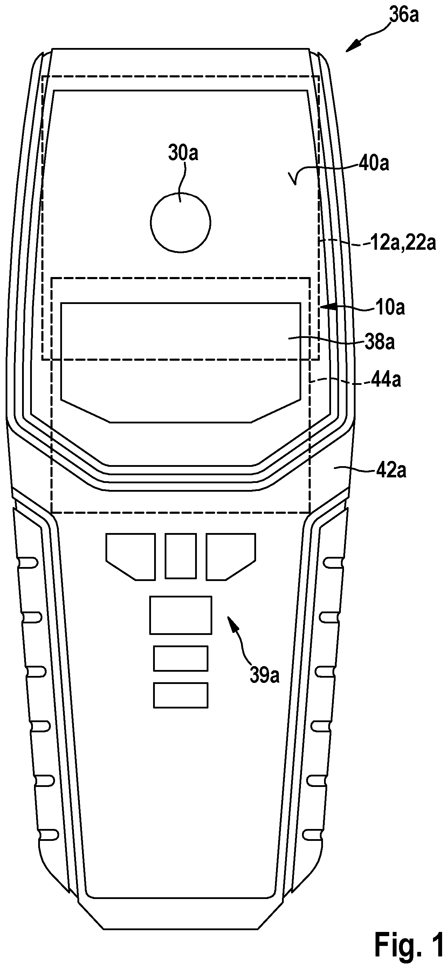

Figur 1 zeigt ein als Handortungsgerät ausgebildetes Handwerkzeug 36a mit einer erfindungsgemäßen Handwerkzeugvorrichtung 10a, einer Anzeigeeinheit 38a, einer Bedieneinheit 39a und einem Handwerkzeuggehäuse 42a. Das Handwerkzeuggehäuse 42a umschließt einen Innenraum, in dem die Handwerkzeugvorrichtung 10a angeordnet ist. Die Anzeigeeinheit 38a und die Bedieneinheit 39a sind auf einer Vorderseite 40a des Handwerkzeuggehäuses 42a angeordnet. Das Handwerkzeug 36a ist dazu vorgesehen, bei einem Ortungsvorgang mit einer Rückseite 41a an ein Werkstück 14a angelegt zu werden. Mittels der Bedieneinheit 39a ist die Handwerkzeugvorrichtung 10a von einem Bediener konfigurierbar. Die Handwerkzeugvorrichtung 10a gibt über die Anzeigeeinheit 38a Ortungsergebnisse an den Bediener aus.

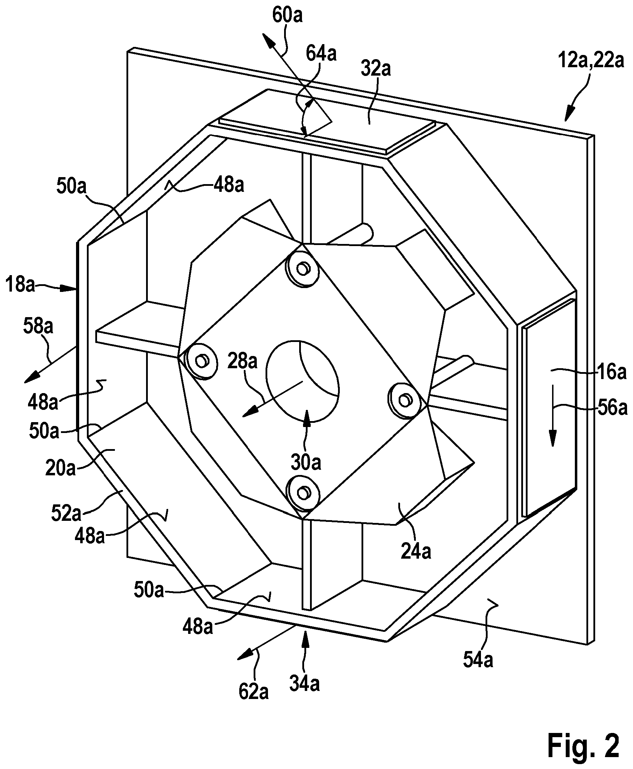

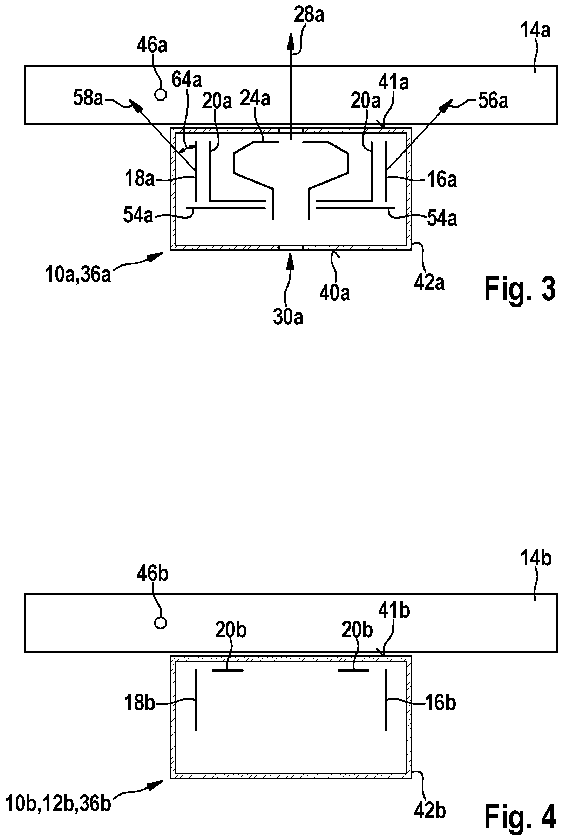

Wie die Figuren 2 und 3 zeigen, umfasst die Handwerkzeugvorrichtung 10a eine erste Ortungsvorrichtung 12a mit vier Ortungsantennen 16a, 18a, 32a, 34a, ein Abschirmmittel 20a, eine zweite Ortungsvorrichtung 22a mit einer Ortungsantenne 24a und eine Ortungselektronik 44a der ersten und der zweiten Ortungsvorrichtung 12a, 22a. Die Ortungselektronik 44a umfasst, hier nicht näher dargestellt, eine Recheneinheit und Signalverarbeitungsvorrichtungen der ersten und der zweiten Ortungsvorrichtung 12a, 22a.

Die Signalverarbeitungsvorrichtungen bereiten von den Ortungsantennen 16a, 18a, 24a, 32a, 34a kommende Ortungssignale für die Recheneinheit auf. Die Signalverarbeitungsvorrichtung der ersten Ortungsvorrichtung 12a umfasst einen Filter und einen Verstärker, die dazu vorgesehen sind, ein empfangenes niederfrequentes Ortungssignal herauszufiltern und zu verstärken. Die Ortungsantennen 16a, 18a, 24a, 32a, 34a sind galvanisch mit einer Leiterplatte der Signalverarbeitungsvorrichtung verbunden. Alternativ könnten die Ortungsantennen 16a, 18a, 24a, 32a, 34a über eine kapazitive Kopplung mit einer Leiterplatte der Signalverarbeitungsvorrichtung verbunden sein.

Die Signalverarbeitungsvorrichtung der zweiten Ortungsvorrichtung 22a umfasst einen Filter und einen Verstärker, die dazu vorgesehen sind, ein empfangenes hochfrequentes Ortungssignal herauszufiltern und zu verstärken. Des Weiteren generiert die Signalverarbeitungsvorrichtung der zweiten Ortungsvorrichtung 22a ein Ortungssignal, das die Ortungsantenne 24a der zweiten Ortungsvorrichtung 22a aussendet.

Die Recheneinheit bestimmt aus empfangenen Ortungssignalen Ortsinformationen von einem in einem Werkstück angeordneten Messobjekt 46a, das eine niederfrequente Wechselspannung führt. Des Weiteren bestimmt die Recheneinheit Ortsinformationen von weiteren nicht näher dargestellten Messobjekten, die das von der Ortungsantenne 24a der zweiten Ortungsvorrichtung 22a ausgesendete Ortungssignal reflektieren. Zudem ist die Recheneinheit dazu vorgesehen zu bestimmen, ob die weiteren Messobjekte die niederfrequente Wechselspannung führen.

. Das Abschirmmittel 20a ist als eine auf eine Innenseite eines Trägers 52a der Handwerkzeugvorrichtung10a aufgetragene metallische Schicht ausgebildet. Das Abschirmmittel 20a ist als eine senkrecht zu der Vorderseite 40a des Handwerkzeuggehäuses 42a verlaufende Röhre ausgebildet. Das Abschirmmittel 20a weist einen achteckigen Querschnitt auf einer Ebene auf, die parallel zu der Vorderseite 40a des Handwerkzeuggehäuses 42a ausgerichtet ist. Die einzelnen Flächen 48a des Abschirmmittels 20a sind entlang von Stoßkanten 50a der Flächen 48a leitend miteinander verbunden

Die vier Ortungsantennen 16a, 18a, 32a, 34a der ersten Ortungsvorrichtung 12a sind als auf eine Außenseite des Trägers 52a aufgetragene metallische, elektrisch leitende Schichten ausgebildet. Die vier Ortungsantennen 16a, 18a, 32a, 34a sind zu der jeweils benachbart angeordneten Ortungsantenne 16a, 18a, 32a, 34a jeweils um 90 Grad versetzt angeordnet. Somit ist das Abschirmmittel 20a jeweils zwischen den Ortungsantennen 16a, 18a, 32a, 34a angeordnet. Die Ortungsantennen 16a, 18a, 32a, 34a der ersten Ortungsvorrichtung 12a sind symmetrisch zu dem Abschirmmittel 20a angeordnet.

Das Abschirmmittel 20a umschließt die Ortungsantenne 24a der zweite Ortungsvorrichtung 22a auf Ebenen, die parallel zu der Vorderseite 40a des Handwerkzeuggehäuses 42a ausgerichtet sind, vollständig. Die Ortungsantenne 24a der zweiten Ortungsvorrichtung 22a ist dazu vorgesehen, ein hochfrequentes Ortungssignal auszusenden und zu empfangen. Die Handwerkzeugvorrichtung 10a umfasst eine Massefläche 54a, die zwischen der Vorderseite 40a des Handwerkzeuggehäuses 42a und der Ortungsantenne 24a der zweiten Ortungsvorrichtung 22a angeordnet ist. Des Weiteren ist die Massefläche 54a zwischen den Ortungsantennen 16a, 18a, 32a, 34a der ersten Ortungsvorrichtung 12a und der Vorderseite 40a des Handwerkzeuggehäuse 42a angeordnet. Die Massefläche 54a und das Abschirmmittel 20a sind elektrisch voneinander getrennt. Hier ist zwischen der Massefläche 54a und dem Abschirmmittel 20a ein Spalt.

Die Ortungsantenne 24a der zweite Ortungsvorrichtung 22a und das Handwerkzeuggehäuse 42a weisen eine Funktionsöffnung 30a auf. Durch die Funktionsöffnung 30a kann ein nicht näher dargestelltes Funktionsmittel senkrecht zu der Vorderseite 40a des Handwerkzeuggehäuses 42a durch das Handwerkzeug 36a zu dem Werkstück 14a geführt werden. Die Ortungsantennen 16a, 18a, 32a, 34a der ersten Ortungsvorrichtung 12a sind symmetrisch zu der Ortungsantenne 24a der zweiten Ortungsvorrichtung 22a und der Funktionsöffnung 30a angeordnet.

Die Ortungsantenne 24a der zweiten Ortungsvorrichtung 22a weist eine Hauptortungsrichtung 28a auf, die senkrecht zu der Rückseite 41a des Handwerkzeuggehäuses 42a ausgerichtet ist. Die Ortungsantennen 16a, 18a, 32a, 34a der ersten Ortungsvorrichtung 12a weisen Hauptortungsrichtungen 56a, 58a, 60a, 62a auf, die von dem Abschirmmittel 20a weg gerichtet sind. Des Weiteren sind die Hauptortungsrichtungen 56a, 58a, 60a, 62a von der Massefläche 54a weg gerichtet. Somit weisen die Hauptortungsrichtungen 56a, 58a, 60a, 62a zu der Rückseite 41a des Handwerkzeuggehäuses 42a einen Winkel 64a von etwa 45 Grad auf. Durch unterschiedliche Abstände der Ortungsantennen 16a, 18a, 32a, 34a der ersten Ortungsvorrichtung 12a zu dem Abschirmmittel 20a und/oder zu der Massefläche 54a sind andere, dem Fachmann als sinnvoll erscheinende Hauptortungsrichtungen möglich. Alternativ könnten die Hauptortungsrichtungen der Ortungsantennen 16a, 18a, 32a, 34a der ersten Ortungsvorrichtung 12a parallel zu der Rückseite 41a des Handwerkzeuggehäuses 42a ausgerichtet sein. Die Ortungsantennen 16a, 18a, 32a, 34a der ersten Ortungsvorrichtung 12a weisen Haupterstreckungsebenen auf, die parallel zu der Hauptortungsrichtung 28a der Ortungsantenne 24a der zweiten Ortungsvorrichtung 22a ausgerichtet sind.

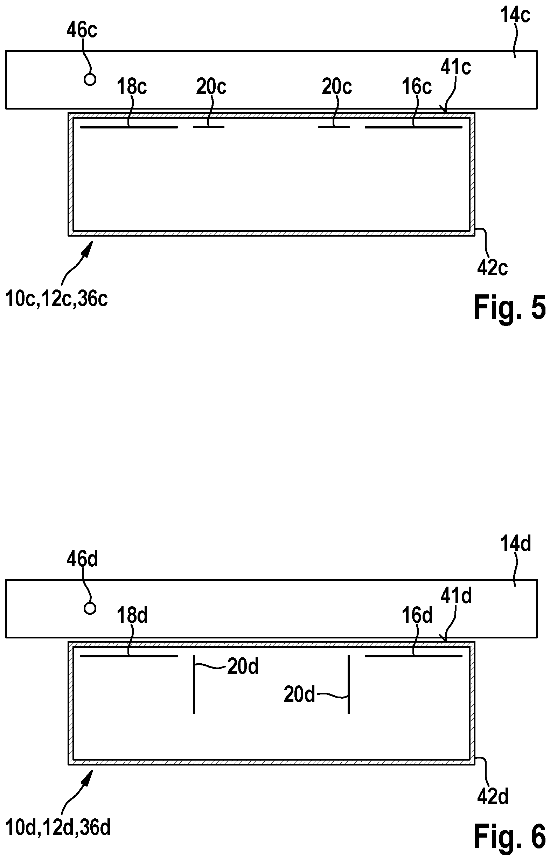

In den Figuren 4 und 6 sind drei weitere Ausführungsbeispiele der Erfindung gezeigt. Die nachfolgenden Beschreibungen und die Zeichnungen beschränken sich im Wesentlichen auf die Unterschiede zwischen den Ausführungsbeispielen, wobei bezüglich gleich bezeichneter Bauteile, insbesondere in Bezug auf Bauteile mit gleichen Bezugszeichen, grundsätzlich auch auf die Zeichnungen und/oder die Beschreibung der anderen Ausführungsbeispiele, insbesondere der Figuren 1 bis 3, verwiesen werden kann. Zur Unterscheidung der Ausführungsbeispiele ist der Buchstabe a den Bezugszeichen des Ausführungsbeispiels in den Figuren 1 bis 3 nachgestellt. In den Ausführungsbeispielen der Figuren 4 bis 6 ist der Buchstabe a durch die Buchstaben b bis d ersetzt.

Figur 4 zeigt ein Handwerkzeug 36b mit einer Handwerkzeugvorrichtung 10b und einem Handwerkzeuggehäuse 42b. Die Handwerkzeugvorrichtung 10b umfasst eine Ortungsvorrichtung 12b und ein Abschirmmittel 20b. Die Ortungsvorrichtung 12b ist dazu vorgesehen, eine niederfrequente Wechselspannung eines Messobjekts 46b in einem Werkstück 14b zu orten. Die Ortungsvorrichtung 12b weist eine erste Ortungsantenne 16b und eine zweite Ortungsantenne 18b auf. Das Abschirmmittel 20b ist dazu vorgesehen, ein niederfrequentes Ortungssignal abzuschirmen. Das Abschirmmittel 20b ist zwischen der ersten Ortungsantenne 16b und der zweiten Ortungsantenne 18b angeordnet. Das Abschirmmittel 20b ist als eine Schicht ausgebildet, deren Haupterstreckungsebene parallel zu einer Rückseite 41b des Handwerkzeuggehäuses 42b ausgerichtet ist. Die Ortungsantennen 16b, 18b der Ortungsvorrichtung 12b sind jeweils als eine Schicht ausgebildet, deren Haupterstreckungsebene jeweils senkrecht zu der Rückseite 41b des Handwerkzeuggehäuses 42b ausgerichtet ist.

Figur 5 soll nicht als eine Ausführungsform der Erfindung aufgefasst werden. Figur 5 zeigt ein Handwerkzeug 36c mit einer Handwerkzeugvorrichtung 10c und einem Handwerkzeuggehäuse 42c. Die Handwerkzeugvorrichtung 10c umfasst eine Ortungsvorrichtung 12c und ein Abschirmmittel 20c. Die Ortungsvorrichtung 12c ist dazu vorgesehen, eine niederfrequente Wechselspannung eines Messobjekts 46c in einem Werkstück 14c zu orten. Die Ortungsvorrichtung 12c weist eine erste Ortungsantenne 16c und eine zweite Ortungsantenne 18c auf. Das Abschirmmittel 20c ist dazu vorgesehen, ein niederfrequentes Ortungssignal abzuschirmen. Das Abschirmmittel 20c ist zwischen der ersten Ortungsantenne 16c und der zweiten Ortungsantenne 18c angeordnet. Das Abschirmmittel 20c ist als eine Schicht ausgebildet, deren Haupterstreckungsebene jeweils parallel zu der Rückseite 41c des Handwerkzeuggehäuses 42c ausgerichtet ist.

Figur 6 zeigt ein Handwerkzeug 36d mit einer Handwerkzeugvorrichtung 10d und einem Handwerkzeuggehäuse 42d. Die Handwerkzeugvorrichtung 10d umfasst eine Ortungsvorrichtung 12d und ein Abschirmmittel 20d. Die Ortungsvorrichtung 12d ist dazu vorgesehen, eine niederfrequente Wechselspannung eines Messobjekts 46d in einem Werkstück 14d zu orten. Die Ortungsvorrichtung 12d weist eine erste Ortungsantenne 16d und eine zweite Ortungsantenne 18d auf. Das Abschirmmittel 20d ist dazu vorgesehen, ein niederfrequentes Ortungssignal abzuschirmen. Das Abschirmmittel 20d ist zwischen der ersten Ortungsantenne 16d und der zweiten Ortungsantenne 18d angeordnet. Das Abschirmmittel 20d ist als eine Schicht ausgebildet, deren Haupterstreckung senkrecht zu einer Rückseite 41d des Handwerkzeuggehäuses 42d ausgerichtet ist. Die Ortungsantennen 16d, 18d der Ortungsvorrichtung 12d sind jeweils als eine Schicht ausgebildet, deren Haupterstreckungsebene jeweils parallel zu der Rückseite 41d des Handwerkzeuggehäuses 42d ausgerichtet ist.

## Patentansprüche

1. Handwerkzeugvorrichtung mit zumindest einer Ortungsvorrichtung (12a-d), die dazu vorgesehen ist, eine niederfrequente Wechselspannung in einem Werkstück (14a-d) zu orten und die zumindest eine erste Ortungsantenne (16a-d), eine zweite Ortungsantenne (18a-d) und ein Abschirmmittel (20a-d) zur Abschirmung eines niederfrequenten Ortungssignals aufweist, das zwischen der ersten Ortungsantenne (16a-d) und der zweiten Ortungsantenne (18a-d) angeordnet ist, wobei die erste und die zweite Ortungsantenne (16a-d; 18a-d) sich entlang paralleler Flächen erstrecken, **dadurch gekennzeichnet, dass** mindestens ein Teil des Abschirmmittels (20a-d) senkrecht zu den Ortungsantennen (16a-d; 18a-d) verläuft, so dass das Abschirmmittel (20a-d) Hauptortungsrichtungen (56a, 58a, 60a, 62a) der Ortungsantennen (16a-d, 18a-d), d.h. solche Richtungen, in denen eine jeweilige Ortungsantenne eine maximale Empfindlichkeit aufweist, beeinflusst.

2. Handwerkzeugvorrichtung nach Anspruch 1, **dadurch gekennzeichnet, dass** das Abschirmmittel (20a-d) derart angeordnet ist, dass Hauptortungsrichtungen (56a, 58a, 60a, 62a) der Ortungsantennen (16a-d, 18a-d) in unterschiedliche Richtungen ausgerichtet sind.

3. Handwerkzeugvorrichtung nach einem der vorhergehenden Ansprüche, **gekennzeichnet durch** eine Recheneinheit, die aus von den Ortungsantennen (16a, 18a) in Hauptortungsrichtungen (56a, 58a, 60a, 62a) empfangenen Ortungssignalen Ortsinformationen von einem in einem Werkstück angeordneten Messobjekt 46a, das eine niederfrequente Wechselspannung führt, bestimmt.

4. Handwerkzeugvorrichtung nach einem der vorhergehenden Ansprüche, **dadurch gekennzeichnet, dass** die Ortungsantennen (16a-d, 18a-d) symmetrisch zu dem Abschirmmittel (20a-d) angeordnet sind.

5. Handwerkzeugvorrichtung nach einem der vorhergehenden Ansprüche, **dadurch gekennzeichnet, dass** die erste und/oder die zweite Ortungsantenne (16a-d, 18a-d) von einer leitenden Schicht gebildet ist.

6. Handwerkzeugvorrichtung nach einem der vorhergehenden Ansprüche, **gekennzeichnet durch** eine zweite Ortungsvorrichtung (22a) mit zumindest einer Ortungsantenne (24a), wobei das Abschirmmittel (20a) die Ortungsantenne (24a) der zweiten Ortungsvorrichtung (22a) zumindest im Wesentlichen umschließt.

7. Handwerkzeugvorrichtung nach Anspruch 6, **dadurch gekennzeichnet, dass** die zweite Ortungsvorrichtung (22a) dazu vorgesehen ist, mit einem hochfrequenten Ortungssignal zu orten.

8. Handwerkzeugvorrichtung zumindest nach Anspruch 6, **dadurch gekennzeichnet, dass** die erste und die zweite Ortungsantenne (16a, 18a) symmetrisch zu der Ortungsantenne (24a) der zweiten Ortungsvorrichtung (22a) angeordnet sind.

9. Handwerkzeugvorrichtung zumindest nach Anspruch 6, **dadurch gekennzeichnet, dass** die erste und die zweite Ortungsantenne (16a, 18a) eine Haupterstreckungsebene aufweisen, die im Wesentlichen parallel zu einer Hauptortungsrichtung (28a) der Ortungsantenne (24a) der zweiten Ortungsvorrichtung (22a) ausgerichtet ist.

10. Handwerkzeugvorrichtung nach einem der vorhergehenden Ansprüche, **gekennzeichnet durch** eine Funktionsöffnung (30a), wobei zumindest zwei der Ortungsantennen (16a, 18a) symmetrisch zu der Funktionsöffnung (30a) angeordnet sind.

11. Handwerkzeugvorrichtung nach einem der vorhergehenden Ansprüche, **dadurch gekennzeichnet, dass** die erste Ortungsvorrichtung (12a) eine dritte Ortungsantenne (32a) und eine vierte Ortungsantenne (34a) aufweist, wobei das Abschirmmittel (20a) zwischen der dritten Ortungsantenne (32a) und der vierten Ortungsantenne (34) angeordnet ist.

12. Handwerkzeug mit einer Handwerkzeugvorrichtung (10a-d) nach einem der vorhergehenden Ansprüche.

## Claims

1. Hand tool device with at least one locating device (12a-d) which is provided in order to locate a low-frequency AC voltage in a workpiece (14a-d) and which has at least a first locating antenna (16a-d), a second locating antenna (18a-d) and a shielding means (20a-d) intended for shielding a low-frequency locating signal and arranged between the first locating antenna (16a-d) and the second locating antenna (18a-d), the first and the second locating antenna (16a-d; 18a-d) extending along parallel surfaces, **characterized in that** at least part of the shielding means (20a-d) extends perpendicularly to the locating antennas (16a-d; 18a-d) such that the shielding means (20a-d) influences main locating directions (56a, 58a, 60a, 62a) of the locating antennas (16a-d, 18a-d), i.e. such directions in which a respective locating antenna has a maximum sensitivity.

2. Hand tool device according to Claim 1, **characterized in that** the shielding means (20a-d) is arranged in such a way that main locating directions (56a, 58a, 60a, 62a) of the locating antennas (16a-d, 18a-d) are aligned in different directions.

3. Hand tool device according to one of the preceding claims, **characterized by** a computing unit which determines from locating signals received from the locating antennas (16a, 18a) in main locating directions (56a, 58a, 60a, 62a) locational information of an object of measurement 46a that is arranged in a workpiece and carries a low-frequency AC voltage.

4. Hand tool device according to one of the preceding claims, **characterized in that** the locating antennas (16a-d, 18a-d) are arranged symmetrically in relation to the shielding means (20a-d).

5. Hand tool device according to one of the preceding claims, **characterized in that** the first and/or the second locating antenna (16a-d, 18a-d) is formed by a conducting layer.

6. Hand tool device according to one of the preceding claims, **characterized by** a second locating device (22a) with at least one locating antenna (24a), the shielding means (20a) at least substantially enclosing the locating antenna (24a) of the second locating device (22a).

7. Hand tool device according to Claim 6, **characterized in that** the second locating device (22a) is provided in order to locate with a high-frequency locating signal.

8. Hand tool device at least according to Claim 6, **characterized in that** the first and the second locating antenna (16a, 18a) are arranged symmetrically in relation to the locating antenna (24a) of the second locating device (22a).

9. Hand tool device at least according to Claim 6, **characterized in that** the first and the second locating antenna (16a, 18a) have a main plane of extent that is aligned substantially parallel to a main locating direction (28a) of the locating antenna (24a) of the second locating device (22a).

10. Hand tool device according to one of the preceding claims, **characterized by** a functional opening (30a), at least two of the locating antennas (16a, 18a) being arranged symmetrically in relation to the functional opening (30a).

11. Hand tool device according to one of the preceding claims, **characterized in that** the first locating device (12a) has a third locating antenna (32a) and a fourth locating antenna (34a), the shielding means (20a) being arranged between the third locating antenna (32a) and the fourth locating antenna (34).

12. Hand tool with a hand tool device (10a-d) according to one of the preceding claims.

## Revendications

1. Dispositif formant outil à main, comprenant au moins un dispositif de localisation (12a-d) qui est prévu pour localiser une tension alternative basse fréquence dans une pièce (14a-d) et qui présente au moins une première antenne de localisation (16a-d), une deuxième antenne de localisation (18a-d) et un moyen de blindage (20a-d) pour déparasiter un signal de localisation basse fréquence, qui est disposé entre la première antenne de localisation (16a-d) et la deuxième antenne de localisation (18a-d), dans lequel la première et la deuxième antenne de localisation (16a-d ; 18a-d) s'étendent le long de surfaces parallèles, **caractérisé en ce qu'**au moins une partie du moyen de blindage (20a-d) passe perpendiculairement aux antennes de localisation (16a-d ; 18a-d) de sorte que le moyen de blindage (20a-d) affecte des directions de localisation principales (56a, 58a, 60a, 62a) des antennes de localisation (16a-d, 18a-d), c'est-à-dire les directions dans lesquelles une antenne de localisation respective présente une sensibilité maximale.

2. Dispositif formant outil à main selon la revendication 1, **caractérisé en ce que** le moyen de blindage (20a-d) est disposé de telle sorte que les directions de localisation principales (56a, 58a, 60a, 62a) des antennes de localisation (16a-d, 18a-d) sont orientées dans différentes directions.

3. Dispositif formant outil à main selon l'une quelconque des revendications précédentes, **caractérisé par** une unité de calcul qui détermine à partir de signaux de localisation reçus par les antennes de localisation (16a, 18a) dans des directions de localisation principales (56a, 58a, 60a, 62a) des informations le lieu d'un objet de mesure (46a) disposé dans une pièce et qui conduit une tension alternative basse fréquence.

4. Dispositif formant outil à main selon l'une quelconque des revendications précédentes, **caractérisé en ce que** les antennes de localisation (16a-d, 18ad) sont disposées de manière symétrique au moyen de blindage (20a-d).

5. Dispositif formant outil à main selon l'une quelconque des revendications précédentes, **caractérisé en ce que** la première et/ou la deuxième antenne de localisation (16a-d, 18a-d) sont formées par une couche conductrice.

6. Dispositif formant outil à main selon l'une quelconque des revendications précédentes, **caractérisé par** un deuxième dispositif de localisation (22a) pourvu d'au moins une antenne de localisation (24a), le moyen de blindage (20a) et l'antenne de localisation (24a) entourant au moins substantiellement le deuxième dispositif de localisation (22a).

7. Dispositif formant outil à main selon la revendication 6, **caractérisé en ce que** le deuxième dispositif de localisation (22a) est prévu pour une localisation avec un signal de localisation haute fréquence.

8. Dispositif formant outil à main au moins selon la revendication 6, **caractérisé en ce que** la première et la deuxième antenne de localisation (16a, 18a) sont disposées de manière symétrique par rapport à l'antenne de localisation (24a) du deuxième dispositif de localisation (22a).

9. Dispositif formant outil à main au moins selon la revendication 6, **caractérisé en ce que** la première et la deuxième antenne de localisation (16a, 18a) présentent un plan d'extension principal qui est orienté substantiellement en parallèle à une direction de localisation principale (28a) de l'antenne de localisation (24a) du deuxième dispositif de localisation (22a).

10. Dispositif formant outil à main selon l'une quelconque des revendications précédentes, **caractérisé par** une ouverture fonctionnelle (30a), dans lequel au moins deux des antennes de localisation (16a, 18a) sont disposées de manière symétrique par rapport à l'ouverture fonctionnelle (30a).

11. Dispositif formant outil à main selon l'une quelconque des revendications précédentes, **caractérisé en ce que** le premier dispositif de localisation (12a) présente une troisième antenne de localisation (32a) et une quatrième antenne de localisation (34a), le moyen de blindage (20a) étant disposé entre la troisième antenne de localisation (32a) et la quatrième antenne de localisation (34).

12. Outil à main comprenant un dispositif formant outil à main (10a-d) selon l'une quelconque des revendications précédentes.
